# EUROPÄISCHE PATENTSCHRIFT

(11) **EP 3 583 414 B1**
(45) Veröffentlichungstag und Bekanntmachung des Hinweises auf die Patenterteilung: **24.02.2021**
(21) Anmeldenummer: 18717288.7
(22) Anmeldetag: 04.04.2018
(51) Int. Cl.: G01N 27/90, G01R 33/02, G01R 33/12, H01F 5/00, G01N 27/87

(54) **DIFFERENZSONDE, PRÜFVORRICHTUNG UND HERSTELLUNGSVERFAHREN**
DIFFERENTIAL PROBE, TESTING DEVICE AND PRODUCTION METHOD
SONDE DE DIFFÉRENCE, DISPOSITIF DE CONTRÔLE ET PROCÉDÉ DE FABRICATION

(30) Priorität: 10.04.2017 DE 102017107708
(43) Veröffentlichungstag der Anmeldung: 25.12.2019
(73) Patentinhaber: Prüftechnik Dieter Busch GmbH, 85737 Ismaning (DE)
(72) Erfinder: FUCHSLOCH, Bernd, 71093 Weil im Schönbuch (DE); PETERS, Jürgen, 85652 Pliening (DE)
(86) Internationale Anmeldenummer: PCT/EP2018/058536
(87) Internationale Veröffentlichungsnummer: WO 2018/189000

(56) Entgegenhaltungen:
- WO-A1-2016/080947
- DE-A1-102013 209 808
- US-A- 3 504 276
- US-A- 3 900 793
- US-A- 5 659 248

## Beschreibung

Die vorliegende Erfindung betrifft eine Prüfvorrichtung mit wenigstens einer Differenzsonde, die eine erste Halbsonde und eine zweite Halbsonde und die wenigstens ein Leiterschleifenpaar mit einer ersten Leiterschleife der ersten Halbsonde und einer zweiten Leiterschleife der zweiten Halbsonde aufweist, und insbesondere einer Differenzsonde für die Untersuchung von Prüflingen oder Halbzeugen auf Fehler wie Risse und Lunker. Die Prüfvorrichtung weist wenigstens eine Durchgangsöffnung für Prüflinge auf, um welche die Differenzsonde drehbar ist. Ferner betrifft die Erfindung ein Verfahren zur Herstellung einer Differenzsonde, bei dem Leiterschleifen der Halbsonden auf Platinen ausgebildet werden.

Aus der DE 10 2013 209 808 A1 ist ein Sensor mit drei mit ihren Flachseiten parallel zueinander gestapelt angeordneten und sich teilweise überlappenden Flachspulen bekannt. Die beiden äußeren Flachspulen haben gleiche magnetische Eigenschaften und werden in einer Differenzschaltung betrieben.

Eine dreidimensionale Anordnung von Wirbelstromerfassungselementen, die in mehreren zweidimensionalen Schichten angeordnet sind, ist in der US 5,659,248 gezeigt. Erfassungselemente unterschiedlicher Schichten sind dabei im Wesentlichen identisch konfiguriert und versetzt angeordnet, so dass die Erfassungselemente einer Schicht zumindest teilweise eine Inspektionsoberfläche überdecken, die nicht von Erfassungselementen einer anderen Schicht bedeckt sind.

Die US 3,504,276 offenbart die Herstellung von Leiterschleifen einer Differenzsonde, die auf einer gemeinsamen Platine angeordnet sind, wobei die Platine während der Herstellung zersägt wird.

Ein magnetischer Detektor zur Untersuchung von Röhren ist in der WO 2016/080947 A1 gezeigt. Der Detektor umfasst mehrere Sätze von Differential-Magnetometern, wobei jeder Satz zwei nicht-Differential-Magnetometer umfasst, die über den Durchmesser eines zu messenden Rohres angeordnet sind.

Für die Untersuchung von Halbzeugen auf Fehler wie Risse und Lunker mittels Wirbelstrom- oder Streuflussverfahren kommen Prüfvorrichtungen oder Prüfgeräte zum Einsatz, die als Rotiersysteme ausgebildet sind. Bei derartigen Rotiersystemen sind Sondeneinrichtungen an drehbaren Rotierköpfen des Prüfgeräts angeordnet. Indem der Rotierkopf mitsamt den daran angeordneten Sondeneinrichtungen gedreht wird während ein länglicher Prüfling durch eine mittige Durchlassöffnung durch den Rotierkopf hindurch geschoben wird, bewegen sich die Sondeneinrichtungen relativ zum Prüfling auf einer schraubenförmigen Bahn. Um Magnetfeldänderungen infolge von Fehlerstellen des Prüflings erfassen zu können, müssen sich für das WirbelstromVerfahren vorgesehene Sonden der Sondeneinrichtungen in einem vorgegebenen Abstand bzw. möglichst nahe an der Oberfläche des Prüflings befinden. Beim Streuflussverfahren hingegen stehen die Sonden in Kontakt mit dem Prüfling und schleifen auf dessen Oberfläche.

Ein Defekt liefert das maximal mögliche Signal, wenn die ganze Sonde vollständig bedeckt wird. Ein kurzer Defekt oder eine teilweise Bedeckung der Sonde erzeugen geringere Fehlersignale. Da sich der Prüfling während der Messung translatorisch bewegt während sich der Rotierkopf um den Prüfling dreht, hängt die Mindestfehlerlänge eines Defektes, also die kleinste Länge die ein Defekt im Prüfling aufweisen darf, um als solcher erkannt zu werden, von der Drehzahl und der Vorschub- oder Liniengeschwindigkeit des Prüflings während der Messung ab. Um die Effektivität solcher Rotiersysteme zu verbessern und die Durchlaufgeschwindigkeit der Prüflinge zu erhöhen und dennoch Defekte mit kurzen Mindestfehlerlängen registrieren zu können ist es bekannt, statt einzelner Sonden Sondensysteme mit mehreren hintereinander angeordneten Sonden zu verwenden. Dabei werden die Sonden bevorzugt als Differenzsonden ausgeführt, um störende Einflüsse von Signalsendern zu reduzieren.

Beispielsweise sind aus der US 2010/0312494 A1 und der EP 1 600 769 A1 Differenzsonden bekannt, die im Wirbelstromverfahren eingesetzt werden können. Die Differenzsonden weisen jeweils zwei nebeneinander angeordnete Halbsonden mit jeweilige Flächen umgrenzenden Leiterschleifen auf, wobei die umgrenzten Flächen in derselben Ebene oder parallelen Ebenen angeordnet sind.

Darüber hinaus ist aus der US 2011/0057629 A1 eine gestapelte Anordnung von Leiterplatinen mit darauf ausgebildeten oder gedruckten, als Leiterschleifen ausgeformten Leiterbahnen bekannt. Infolge der Stapelung befinden sich von den Leiterbahnen umgrenzte Flächen miteinander in einer fluchtenden Anordnung. Mittels derartiger gestapelter Platinen und der darauf ausgebildeten Leiterschleifen lassen sich beispielsweise zwei Spulen mit jeweils unterschiedlichen Wickelrichtungen ausbilden. Diese beiden Spulen bilden somit zwei Halbsonden einer Differenzsonde, wobei ein Platinenkern für den gewünschten Abstand zwischen den Halbsonden sorgt, um eine spezifische Wirkbreite der Differenzsonde zu erhalten. Nach Verpressen der beiden Halbsonden mit dem Platinenkern wird die fertige Differenzsonde erhalten.

Es ist bekannt, Mindestfehlerlängen von Rotiersystemen oder Prüfvorrichtungen zu verringern, indem man Differenzsonden verringerter Länge geeignet kombiniert. Wird zum Beispiel die Länge einer Differenzsonde halbiert und werden zwei benachbarte Differenzsonden parallel geschaltet, so müssen Defekte des Prüflings nunmehr nur halb so lange Sonden abdecken, um erkannt zu werden. Infolgedessen lässt sich die Mindestfehlerlänge von Rotiersystemen oder Prüfvorrichtungen halbieren. Allerdings bringt sich der Innenwiderstand nicht aktiver Differenzsonden als Spannungsteiler in derartig verschaltete Differenzsonden ein, so dass auch ein von den Differenzsonden gelieferter Signalpegel halbiert wird. Derartig parallel geschaltete Differenzsonden zeigen daher ein identisches Verhalten wie eine einzige Differenzsonde, deren Länge derjenigen der beiden parallel geschalteten Differenzsonden entspricht, was wiederum eine aufwändige Elektronik zum Ausgleichen dieses Verhaltens erforderlich macht.

Es ist daher die Aufgabe der vorliegenden Erfindung, eine Prüfvorrichtung mit einer einfach herzustellenden Differenzsonde und ein Herstellungsverfahren für eine derartige Differenzsonde zu schaffen, so dass sich eine Liniengeschwindigkeit von Prüflingen bei gleichbleibender Mindestfehlerlänge und ohne Verluste an Auswertegenauigkeit erhöhen lässt.

Diese Aufgabe wird durch die Prüfvorrichtung mit den Merkmalen des Anspruchs 1 und durch das Verfahren mit den Merkmalen des Anspruchs 7 gelöst. Bevorzugte Ausführungsformen sind Gegenstand der abhängigen Ansprüche.

Bei der Differenzsonde der erfindungsgemäßen Prüfvorrichtung sind die erste Leiterschleife und die zweite Leiterschleife des Leiterschleifenpaares zueinander spiegelbildlich ausgeformt und bezüglich einer spiegelbildlichen Anordnung derselben auf jeweiligen Seiten einer gedachten Spiegelebene, bei der die erste Leiterschleife und die zweite Leiterschleife zur Spiegelebene parallel orientiert sind, in einer ebenfalls zur Spiegelebene parallelen Versetzungsrichtung gegeneinander versetzt angeordnet, wobei sich die erste Leiterschleife und die zweite Leiterschleife in Normalenrichtung zur Spiegelebene teilweise überlappen. Insbesondere können die auf jeweiligen Seiten der Spiegelebene angeordnete erste und zweite Halbsonde bzw. die erste und zweite Leiterschleife zudem auch in der Normalenrichtung zur Spiegelebene gegeneinander versetzt bzw. von der sich zwischen den beiden Leiterschleifen befindlichen Spiegelebene jeweils beabstandet sein. Hierbei sind eine von der ersten Leiterschleife umschlossene oder umgrenzte erste Fläche und eine von der zweiten Leiterschleife umschlossene oder umgrenzte zweite Fläche zueinander parallel bzw. zur Spiegelebene parallel orientiert. Infolge der in der zur Spiegelebene parallelen Versetzungsrichtung versetzten Anordnung der beiden Leiterschleifen und insbesondere der beiden Halbsonden wird eine von der Differenzsonde auf dem Prüfling oder Prüfgut überstrichene Fläche vergrößert. Dabei bleibt die Differenzwirkung der Differenzsonde erhalten, deren erste und zweite Halbsonde bzw. erste und zweite Leiterschleife in einer sogenannten Differenzschaltung betreibbar sind.

Ganz allgemein ist die Differenzsonde sowohl für Prüfungen mittels des Wirbelstrom- als auch des Streuflussverfahrens verwendbar. Ferner können die erste und zweite Leiterschleife aus gleichen oder verschiedenen Materialien bzw. Metallen gefertigt bzw. elektrisch leitend sein. Darüber hinaus können die erste Leiterschleife und die zweite Leiterschleife die erste Fläche und die zweite Fläche vollständig oder auch nur teilweise umgrenzen oder umschließen.

Vorzugsweise weist die Differenzsonde mehrere Leiterschleifenpaare auf, bei der alle ersten Leiterschleifen miteinander fluchten und alle zweiten Leiterschleifen miteinander fluchten. Dabei weist jedes Leiterschleifenpaar eine erste Leiterschleife der ersten Halbsonde und eine zu dieser spiegelbildlich ausgebildete zweite Leiterschleife der zweiten Halbsonde auf. Vorteilhafterweise sind die mehreren ersten Leiterschleifen und die mehreren zweiten Leiterschleifen wie jeweilige Spulen mit unterschiedlichen oder gegenläufigen Wickelrichtungen miteinander verbunden bzw. elektrisch leitend miteinander verbunden. Auf diese Weise wirken die erste Halbsonde und die zweite Halbsonde in dieser Ausführungsform wie unterschiedlich gewickelte Spulen.

Obwohl die Form der ersten und zweiten Leiterschleifen grundsätzlich beliebig und beispielsweise kreisförmig, oval, quadratisch oder rechteckförmig sein kann, sind die ersten und zweiten Leiterschleifen bevorzugt von rechteckiger Form. Besonders bevorzugt weisen die erste Leiterschleife und die zweite Leiterschleife jeweilige gerade und zur Versetzungsrichtung parallel ausgebildete Leiterabschnitte auf. Im Betrieb der Differenzsonde sind diese geraden und zur Versetzungsrichtung parallel ausgerichteten Leiterabschnitte vorteilhafterweise dem Prüfling oder dem Prüfgut zugewandt. Wird die Differenzsonde im Wirbelstromverfahren verwendet, so sind diese Leiterabschnitte von einer Oberfläche des Prüflings bzw. vom Prüfling beabstandet, während sie bei einem Betrieb der Differenzsonde im Streuflussverfahren mit der Oberfläche des Prüflings in Kontakt stehen.

Bei der Differenzsonde können sich die von der ersten Leiterschleife umgrenzte erste Fläche und die von der zweiten Leiterschleife umgrenzte zweite Fläche in Normalenrichtung zur Spiegelebene teilweise überlappen oder disjunkt sein. Bevorzugt sind die erste und zweite Leiterscheife bzw. die erste und die zweite Halbsonde in der Versetzungsrichtung soweit gegeneinander versetzt, dass sich die erste Fläche und die zweite Fläche in Normalenrichtung zur Spiegelfläche nicht überlappen oder disjunkt sind. In solchen Fällen bilden die sich einander in Normalenrichtung zur Spiegelfläche überlappenden Teile oder Abschnitte der ersten und zweiten Leiterschleife jeweilige zusammenhängende Teilabschnitte der jeweiligen Leiterschleifen. Werden die beiden Halbsonden beispielsweise um eine volle Länge der Halbsonden auseinander gezogen bzw. in der Versetzungsrichtung versetzt, so sind die erste Fläche und die zweite Fläche disjunkt und die Liniengeschwindigkeit des Prüflings kann hierdurch verdoppelt werden. Sofern sich die erste Fläche und die zweite Fläche in Normalenrichtung zur Spiegelfläche jedoch überlappen oder nicht disjunkt sind, bilden die sich einander in Normalenrichtung zur Spiegelfläche überlappenden Teile oder Abschnitte der ersten und zweiten Leiterschleife jeweils mehrere unzusammenhängende Teilabschnitte der jeweiligen Leiterschleifen.

In der erfindungsgemäßen Prüfvorrichtung ist die Differenzsonde derart angeordnet, dass während des Drehens der Differenzsonde eine Mittelachse der Durchgangsöffnung im Wesentlichen parallel zur Spiegelebene oder innerhalb der Spiegelebene verläuft. Die Differenzsonde bzw. deren erste und zweite Halbsonde bzw. die erste und zweite Leiterschleife stehen somit senkrecht zur Bewegungsrichtung des Prüflings. Eine derartige Prüfvorrichtung ist insbesondere für Prüfungen nach dem Streuflussverfahren geeignet. Weil die erste und zweite Leiterschleife auf jeweiligen Seiten einer Spiegelebene angeordnet sind, sind sie einerseits senkrecht zur Bewegungsrichtung des Prüflings zueinander versetzt, und da sie ferner bezüglich einer Anordnung derselben auf jeweiligen Seiten der Spiegelebene, bei der die erste Leiterschleife und die zweite Leiterschleife zur Spiegelebene parallel orientiert sind, in einer zur Spiegelebene parallelen Versetzungsrichtung gegeneinander versetzt angeordnet sind, sind sie zudem in Bewegungsrichtung des Prüflings versetzt angeordnet. Dabei sind die erste Fläche und die zweite Fläche sowohl zueinander als auch zur Spiegelebene parallel orientiert.

Um größere Oberflächen des Prüflings zu überstreichen und dadurch die Durchlaufgeschwindigkeit des Prüflings zu erhöhen, können bei der Prüfvorrichtung mehrere Differenzsonden vorgesehen sein. Insbesondere können bei der Prüfvorrichtung zwei oder mehrere Differenzsonden in im Wesentlichen gleichen Winkelabständen um die Durchgangsöffnung herum angeordnet sein.

Ferner ist eine Prüfvorrichtung bevorzugt, bei der wenigstens zwei Differenzsonden entlang der Verschiebungsrichtung bzw. einer zur Mittelachse parallelen Linie nebeneinander angeordnet sind. Auch derartige Anordnungen von Differenzsonden erhöhen die Durchlaufgeschwindigkeit des Prüflings, da größere Oberflächen desselben von den Differenzsonden überstrichen werden.

Beim erfindungsgemäßen Verfahren zur Herstellung einer Differenzsonde erweist es sich als vorteilhaft, dass sowohl die erste als auch die zweite Leiterschleife auf jeweiligen Teilabschnitten derselben Platine ausgebildet werden. Dadurch werden Fehlspannungen, die bei bekannten Differenzsonden infolge von Toleranzen der Trägermaterialien und der Herstellungsprozesse auftreten, vermieden. Auch das bei bekannten Differenzsonden auftretende Problem, dass aus den genannten Gründen Empfindlichkeiten der Sonde ungewünscht geändert werden und unterschiedliche Ausgangswerte erzeugt werden, je nachdem an welcher Stelle ein Defekt die Differenzsonde passiert, wird bei mit dem erfindungsgemäßen Verfahren hergestellten Differenzsonden umgangen.

Mit dem erfindungsgemäßen Verfahren können Differenzsonden mit einfachem Aufbau hergestellt werden, die dennoch eine Verringerung der Mindestfehlerlänge um ein Vielfaches erlauben, ohne die Rotationsgeschwindigkeit des Prüflings erhöhen zu müssen. Defekte mit der Mindestfehlerlänge oder länger werden an jeder Stelle unter der Differenzsonde mit der gleichen Empfindlichkeit erkannt. Fehlerschwellen in einer Auswertesoftware lassen sich dadurch eindeutig einstellen. Ferner werden Produktionstoleranzen bei der Herstellung von Differenzsonden minimiert.

Durch zusätzliches Einlegen von Material zwischen den beiden Teilabschnitten kann die Wirkbreite der Differenzsonde beeinflusst werden. Die Teilabschnitte können miteinander verklebt werden. Bevorzugt werden allerdings elektrische Verbindungen zwischen den ersten und zweiten Leiterschleifen direkt als mechanische Verbindungen zwischen denselben verwendet. Bei kleinen Wirkbreiten können die Teilabschnitte beispielsweise direkt aneinander gelegt und die elektrischen Verbindungen mittels Lötzinn hergestellt werden. Durch die entstehende Verbindung werden die Teilabschnitte zueinander fixiert. Bei größeren Wirkbreiten kann vor dem Verlöten zusätzlich ein mechanisches Element eingelegt werden. In der einfachsten Form werden Drähte in die Verbindungen zwischen den Leiterschleifen eingelötet, die gleichzeitig zur elektrischen Verbindung wie auch zur mechanischen Stabilisierung beitragen.

Bevorzugt wird im ersten Teilabschnitt zudem eine erste Leiterschleife oder eine zweite Leiterschleife einer weiteren Differenzsonde und im zweiten Teilabschnitt dem entsprechend eine zweite Leiterschleife oder eine erste Leiterschleife dieser weiteren Differenzsonde ausgebildet. Produktionsschwankungen der Platinen können auf diese Weise ausgemittelt werden. Bei Systemen mit zwei herkömmlich hergestellten, parallelgeschalteten Differenzsonden kann der Ausfall einer Differenzsonde nicht ohne weiteres erkannt werden, da die verbleibende Differenzsonde weiterhin für ein Grundrauschen sorgt. Sind die Differenzsonden jedoch gemäß dieser Ausführungsform des erfindungsgemäßen Verfahrens hergestellt, lässt sich ein Ausfall einer der Differenzsonden von einer Auswertesoftware erkennen. Bei Ausfall durch Unterbrechung fällt das gesamte Signal aus. Hingegen entfällt bei Ausfall durch Kurzschluss die Differenzwirkung der Sonde und das entstehende Signal kann eindeutig als fehlerhaft erkannt werden.

Ferner werden die Teilabschnitte bevorzugt mit Referenzbohrungen versehen, mittels denen die Teilabschnitte relativ zueinander positionierbar sind. Die Referenzbohrungen können von mechanischen Elementen oder Teilen teilweise oder ganz durchdrungen werden, um die Position der Teilabschnitte relativ zueinander zu fixieren.

Nachfolgend wird die Erfindung anhand von bevorzugten Ausführungsbeispielen unter Zuhilfenahme von Figuren näher erläutert. Dabei zeigen:
- Figur 1: eine stark vereinfachte schematische Darstellung einer Prüfvorrichtung;
- Figur 2: eine Differenzsonde;
- Figur 3: zwei Differenzsonden;
- Figur 4a): eine Platine mit aufgedruckten Leiterschleifen;
- Figur 4b): nebeneinander angeordnete Teilabschnitte der Platine der Figur 4a) nach zerteilen.

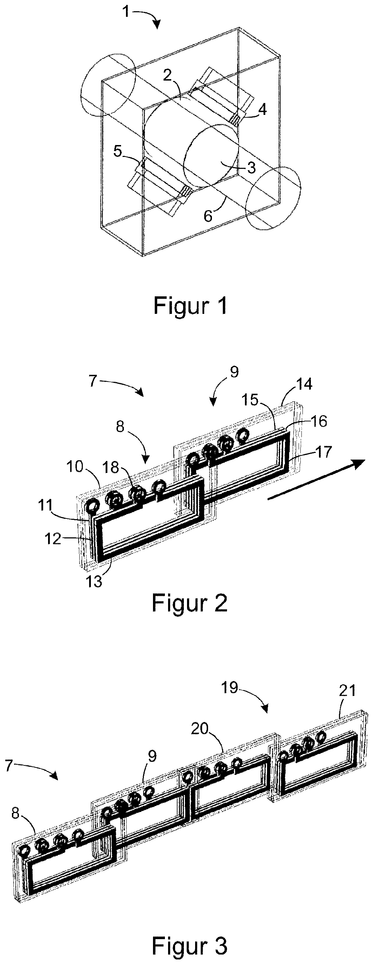

In der Figur 1 ist in einer stark vereinfachten schematischen Darstellung zur Verdeutlichung ihrer Funktionsweise eine Prüfvorrichtung 1 dargestellt. Die Prüfvorrichtung weist einen drehbar gelagerten Rotierkopf 2 mit einer Durchgangsöffnung 3 auf. Zwei Sondeneinrichtungen 4 und 5 zur Streuflussmessung sind diametral am Rotierkopf 2 angeordnet. Jede der Sondeneinrichtungen 4 und 5 kann eine oder mehrere Differenzsonden aufweisen, wie sie weiter unten im Zusammenhang mit den Figuren 2 und 3 näher beschrieben sind.

Mittels der an sich bekannten Streuflussmessung lassen sich Materialfehler in Prüflingen 6 erkennen, die mit einer vorgegebenen Liniengeschwindigkeit durch die Durchgangsöffnung 3 geschoben werden. Hierzu wird der Rotierkopf 2 mit vorgegebener Drehgeschwindigkeit gedreht, während der Prüfling 6 mit der vorgegebenen Liniengeschwindigkeit vorgeschoben wird. Im vorliegenden Fall handelt es sich bei dem Prüfling 6 um einen länglichen Körper. Folglich beschreiben die Sondeneinrichtungen 4 und 5 infolge der Relativbewegung zwischen Rotierkopf 2 und Prüfling 6 jeweilige schraubenförmige Bahnen auf der Oberfläche des Prüflings 6 und tasten den Prüfling 6 entlang dieser Bahnen ab. Sind die Liniengeschwindigkeit des Prüflings 6 und die Drehgeschwindigkeit des Rotierkopfes 2 entsprechend eingestellt, kann von den Sondeneinrichtungen 4 und 5 die gesamte Oberfläche des Prüflings 6 abgetastet werden.

In der Figur 2 ist eine Differenzsonde 7 zu sehen, die in den Sondeneinrichtungen 4 und 5 eingesetzt werden kann. Die Differenzsonde 7 weist eine erste Halbsonde 8 und eine zweite Halbsonde 9 auf. Während ein Stapel aus drei Platinen 10, auf denen jeweilige erste Leiterschleifen 11, 12, und 13 in einer fluchtenden Orientierung ausgebildet sind, die erste Halbsonde 8 bilden, ist die zweite Halbsonde 9 entsprechend aus einem Stapel aus drei Platinen 14 gebildet, auf denen jeweilige zweite Leiterschleifen 15, 16, und 17 in fluchtender Orientierung ausgebildet sind. Dabei bilden die der zweiten Halbsonde 9 zugewandte oder innere erste Leiterschleife 11 und die der ersten Halbsonde 8 zugewandte oder innere zweite Leiterschleife 17 ein erstes Leiterschleifenpaar, die mittlere erste Leiterschleife 12 und die mittlere zweite Leiterschleife 16 bilden ein zweites Leiterschleifenpaar, und die von der zweiten Halbsonde 9 abgewandte oder äußere erste Leiterschleife 13 und die von der ersten Halbsonde 8 abgewandte zweite Leiterschleife 15 bilden ein drittes Leiterschleifenpaar.

Jede der ersten Leiterschleifen 11, 12, und 13 sowie jede der zweiten Leiterschleifen 15, 16, und 17 ist von der Form eines offenen Rechtecks und weist ein jeweiliges Paar von Kontaktendabschnitten 18 auf, mit denen ein elektrischer Kontakt zu benachbarten ersten Leiterschleifen 11, 12, und 13 beziehungsweise zweiten Leiterschleifen 15, 16, und 17 herstellbar ist. Die Verteilung der Kontaktendabschnitte 18 auf den ersten Leiterschleifen 11, 12, 13 und den zweiten Leiterschleifen 15, 16, 17 ist dabei derart, dass die beiden Halbsonden 8 und 9 in einer Anordnung, in der alle ersten Leiterschleifen 11, 12, 13 mit allen zweiten Leiterschleifen 15, 16, 17 fluchten, bezüglich einer sich zwischen den Halbsonden 8 und 9 befindlichen, gedachten Spiegelebene spiegelbildlich ausgebildet sind. Diese spiegelbildliche Ausbildung der beiden Halbsonden 8 und 9 ermöglicht eine leitende Verbindung der ersten Leiterschleifen 11, 12, 13 miteinander und der zweiten Leiterschleifen 15, 16, 17 miteinander auf eine Weise, die zwei Spulen mit jeweils unterschiedlichen oder gegensätzlichen Wickelrichtungen entspricht.

Wie in der Figur 2 zu sehen ist, sind die beiden Halbsonden 8 und 9 jedoch gegenüber der oben beschriebenen Anordnung, in der alle ersten Leiterschleifen 11, 12, 13 mit allen zweiten Leiterschleifen 15, 16, 17 fluchten, gegeneinander verschoben angeordnet. Genauer sind die Halbsonden 8 und 9 und damit deren jeweilige ersten Leiterschleifen 11, 12, 13 und zweiten Leiterschleifen 15, 16, 17 in einer zu dieser Spiegelebene parallelen Richtung verschoben, die in der Figur 2 durch einen geraden Pfeil angedeutet ist. Während jeweilige von den ersten Leiterschleifen 11, 12, 13 umschlossene erste Flächen zueinander fluchtend und parallel zur Spiegelebene und ebenso jeweilige von den zweiten Leiterschleifen 15, 16, 17 umschlossene zweite Flächen zueinander fluchtend und parallel zur Spiegelebene orientiert sind, gibt es keine Überlappung der ersten Flächen und der zweiten Flächen in einer Normalenrichtung zur Spiegelebene. Lediglich zur Verschiebungsrichtung der beiden Halbsonden 8 und 9 senkrechte und einander zugewandte jeweilige Umfangsabschnitte der ersten Leiterschleifen 11, 12, 13 und der zweiten Leiterschleifen 15, 16, 17 sind in einer Normalenrichtung zur Spiegelebene überlappt oder gestapelt angeordnet.

Nach Einbau der Differenzsonde 7 in eine der Sondeneinrichtungen 4 oder 5 liegt eine Mittelachse der Durchgangsöffnung 3 des Prüfkopfes 2, die mit seiner Drehachse identisch ist, im Wesentlichen in der beschriebenen, gedachten Spiegelebene. Zur Verschiebungsrichtung der beiden Halbsonden 8 und 9 parallele Umfangsabschnitte der ersten Leiterschleifen 11, 12, 13 und der zweiten Leiterschleifen 15, 16, 17, an denen die Kontaktendabschnitte 18 vorgesehen sind, sind dabei von der Durchgangsöffnung 3 abgewandt, während diesen Umfangsabschnitten mit den Kontaktendabschnitten 18 entgegengesetzte Umfangsabschnitte der Durchgangsöffnung 3 und somit dem Prüfling 6 zugewandt sind.

Die Differenzsonde 7 kann auch in Kombination mit weiteren, gleichartig aufgebauten Differenzsonden in den Sondeneinrichtungen 4 und 5 vorgesehen sein. Hierzu zeigt die Figur 3 die Differenzsonde 7 in Kombination mit einer gleichartig aufgebauten Differenzsonde 19 mit einer ersten Halbsonde 20 und einer zweiten Halbsonde 21, die in Verlängerung der Differenzsonde 7 in der Verschiebungsrichtung neben dieser angeordnet ist.

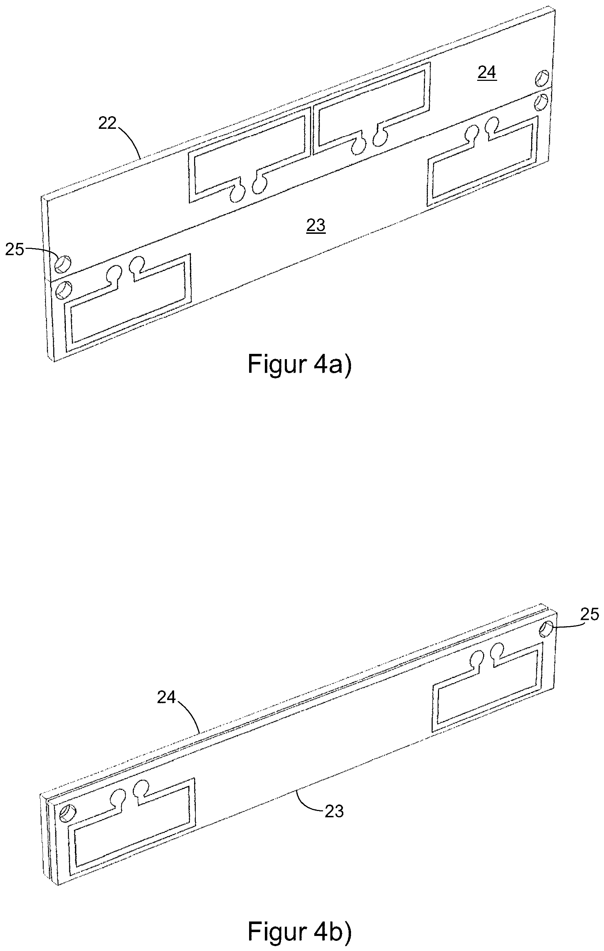

Die beschriebene Differenzsonde 7 und insbesondere die Kombination aus Differenzsonde 7 und Differenzsonde 19 lassen sich besonders einfach herstellen, indem wie in der Figur 4a) gezeigt je eine Leiterschleife der ersten Halbsonde 8 und der zweiten Halbsonde 9 der ersten Differenzsonde 7 und je eine Leiterschleife der ersten Halbsonde 20 und der zweiten Halbsonde 21 der zweiten Differenzsonde 19 an geeigneten Positionen auf derselben Platine 22, jedoch innerhalb verschiedener Teilabschnitte 23 und 24 der Platine ausgebildet werden. Während im dargestellten Beispiel eine erste Leiterschleife der ersten Halbsonde 8 und eine zweite Leiterschleife der zweiten Halbsonde 21 in einem ersten Teilabschnitt 23 der Platine 22 ausgebildet werden, sind eine zweite Leiterschleife der zweiten Halbsonde 9 und eine erste Leiterschleife der ersten Halbsonde 20 in einem zweiten Teilabschnitt 24 der Platine 22 an Positionen ausgebildet, die Versetzungen der Leiterschleifen der zweiten Halbsonden 9 und 21 gegenüber den ersten Halbsonden 8 und 20 in den fertigen Differenzsonden 7 und 19 entsprechen. Hierbei werden die zweite Leiterschleife der zweiten Halbsonde 9 und die erste Leiterschleife der ersten Halbsonde 20 in Orientierungen auf dem zweiten Teilabschnitt 24 ausgebildet, die gegenüber ihren Orientierungen in den fertigen Differenzsonden 7 und 19 bzw. in der fertigen Kombination der Differenzsonden 7 und 19 um eine zur Versetzungsrichtung parallele Drehachse um 180° gedreht sind. Ferner werden Referenzbohrungen 25 in den Teilabschnitten 23 und 24 der Platine 22 vorgesehen, um ein späteres Ausrichten der Teilabschnitte 23 und 24 zu erleichtern.

Nach Zerteilen der Platine 22, wobei die Teilabschnitte 23 und 24 voneinander getrennt werden, werden die beiden Teilabschnitte 23 und 24 nebeneinander angeordnet, wobei insbesondere die auf dem zweiten Teilabschnitt 24 ausgebildeten Leiterschleifen Orientierungen einnehmen, die bezüglich den auf dem ersten Teilabschnitt 23 ausgebildeten Leiterschleifen ihren Orientierungen in den fertigen Differenzsonden 7 und 19 entsprechen. Insbesondere wird einer der beiden Teilabschnitte 23 und 24 hierbei gegenüber dem jeweils anderen Teilabschnitt 23 und 24 um 180° gegenüber der Orientierung des betreffenden Teilabschnittes 23 und 24 in der unzerteilten Platine 22 gedreht.

Beim Anordnen der Teilabschnitte 23 und 24 nebeneinander erweisen sich die Referenzbohrungen 25 als hilfreich. Indem Referenzbohrungen 25 der beiden Teilabschnitte 23 und 24 miteinander zum Fluchten gebracht werden, was einfach durch hindurchstecken eines Körpers durch die Referenzbohrungen 25 geschehen kann, lassen sich die Teilabschnitte 23 und 24 bequem in der gewünschten Weise positionieren. Schließlich werden die Teilabschnitte 23 und 24 miteinander verbunden, was beispielsweise durch verkleben oder auf andere mechanische Weise geschehen kann.

### Bezugszeichenliste

- 1.: Prüfvorrichtung
- 2.: Rotierkopf
- 3.: Durchgangsöffnung
- 4.: Sondeneinrichtung
- 5.: Sondeneinrichtung
- 6.: Prüfling
- 7.: Differenzsonde
- 8.: erste Halbsonde
- 9.: zweite Halbsonde
- 10.: Platine
- 11.: erste Leiterschleife
- 12.: erste Leiterschleife
- 13.: erste Leiterschleife
- 14.: Platine
- 15.: zweite Leiterschleife
- 16.: zweite Leiterschleife
- 17.: zweite Leiterschleife
- 18.: Kontaktendabschnitt
- 19.: Differenzsonde
- 20.: erste Halbsonde
- 21.: zweite Halbsonde
- 22.: Platine
- 23.: Teilabschnitt
- 24.: Teilabschnitt
- 25.: Referenzbohrungen

## Patentansprüche

1. Prüfvorrichtung (1) mit wenigstens einer Differenzsonde (7, 19) und wenigstens einer Durchgangsöffnung (3) für Prüflinge (6), um welche die Differenzsonde (7, 19) drehbar ist, wobei
die Differenzsonde (7, 19) eine erste Halbsonde (8, 20) und eine zweite Halbsonde (9, 21) und
wenigstens ein Leiterschleifenpaar mit einer ersten Leiterschleife (11, 12, 13) der ersten Halbsonde (8, 20) und einer zweiten Leiterschleife (15, 16, 17) der zweiten Halbsonde (9, 21) aufweist,
**dadurch gekennzeichnet, dass**
die erste Leiterschleife (11, 12, 13) und die zweite Leiterschleife (15, 16, 17) zueinander spiegelbildlich ausgeformt und bezüglich einer spiegelbildlichen Anordnung derselben auf jeweiligen Seiten einer Spiegelebene, bei der die erste Leiterschleife (11, 12, 13) und die zweite Leiterschleife (15, 16, 17) zur Spiegelebene parallel orientiert sind, in einer ebenfalls zur Spiegelebene parallelen Versetzungsrichtung gegeneinander versetzt angeordnet sind, wobei
sich die erste Leiterschleife (11, 12, 13) und die zweite Leiterschleife (15, 16, 17) in Normalenrichtung zur Spiegelebene teilweise überlappen, und wobei
während des Drehens der Differenzsonde (7, 19) eine Mittelachse der Durchgangsöffnung (3) im Wesentlichen parallel zur Spiegelebene oder innerhalb der Spiegelebene verläuft.

2. Prüfvorrichtung (1) nach Anspruch 1, bei der die Differenzsonde (7, 19) mehrere Leiterschleifenpaare aufweist, und bei der alle ersten Leiterschleifen (11, 12, 13) miteinander fluchten und alle zweiten Leiterschleifen (15, 16, 17) miteinander fluchten.

3. Prüfvorrichtung (1) nach Anspruch 1 oder 2, wobei bei der Differenzsonde (7, 19) die erste Leiterschleife (11, 12, 13) und die zweite Leiterschleife (15, 16, 17) jeweilige gerade und zur Versetzungsrichtung parallel ausgebildete Leiterabschnitte aufweisen.

4. Prüfvorrichtung (1) nach einem der vorhergehenden Ansprüche, wobei sich bei der Differenzsonde (7, 19) eine von der ersten Leiterschleife (11, 12, 13) umgrenzte erste Fläche und eine von der zweiten Leiterschleife (15, 16, 17) umgrenzte zweite Fläche in Normalenrichtung zur Spiegelebene teilweise überlappen oder disjunkt sind.

5. Prüfvorrichtung (1) nach einem der vorhergehenden Ansprüche, bei der zwei oder mehrere Differenzsonden (7, 19) in im Wesentlichen gleichen Winkelabständen um die Durchgangsöffnung (3) herum angeordnet sind.

6. Prüfvorrichtung (1) nach Anspruch 5, bei der wenigstens zwei Differenzsonden (7, 19) entlang der Versetzungsrichtung nebeneinander angeordnet sind.

7. Verfahren zur Herstellung einer Differenzsonde (7, 19), die eine erste Halbsonde (8, 20) und eine zweite Halbsonde (9, 21) und
wenigstens ein Leiterschleifenpaar mit einer ersten Leiterschleife (11, 12, 13) der ersten Halbsonde (8, 20) und einer zweiten Leiterschleife (15, 16, 17) der zweiten Halbsonde (9, 21) aufweist, deren
erste Leiterschleife (11, 12, 13) und zweite Leiterschleife (15, 16, 17) zueinander spiegelbildlich ausgeformt und bezüglich einer spiegelbildlichen Anordnung derselben auf jeweiligen Seiten einer Spiegelebene, bei der die erste Leiterschleife (11, 12, 13) und die zweite Leiterschleife (15, 16, 17) zur Spiegelebene parallel orientiert sind, in einer ebenfalls zur Spiegelebene parallelen Versetzungsrichtung gegeneinander versetzt angeordnet sind, wobei
sich die erste Leiterschleife (11, 12, 13) und die zweite Leiterschleife (15, 16, 17) in Normalenrichtung zur Spiegelebene teilweise überlappen;
**dadurch gekennzeichnet, dass**
die erste Leiterschleife (11, 12, 13) in einem ersten Teilabschnitt (23) einer flächigen Platine (22) ausgebildet wird,
die zweite Leiterschleife (15, 16, 17) in einem zweiten Teilabschnitt (24) der Platine (22) an einer Position ausgebildet wird, die der Versetzung der zweiten Leiterschleife (15, 16, 17) gegenüber der ersten Leiterschleife (11, 12, 13) in der fertigen Differenzsonde (7, 19) entspricht, wobei die zweite Leiterschleife (15, 16, 17) in einer gegenüber ihrer Orientierung in der fertigen zweiten Halbsonde (9, 21) um eine zur Versetzungsrichtung parallelen Drehachse um 180° gedrehten Orientierung ausgebildet wird,
die Platine (22) geteilt und der erste Teilabschnitt (23) und der zweite Teilabschnitt (24) dabei voneinander getrennt werden,
der zweite Teilabschnitt (24) neben dem ersten Teilabschnitt (23) angeordnet wird, wobei die zweite Leiterschleife (15, 16, 17) in ihre Orientierung in der fertigen zweiten Halbsonde (9, 21) gebracht wird, und
der erste Teilabschnitt (23) und der zweite Teilabschnitt (24) miteinander verbunden werden.

8. Verfahren nach Anspruch 7, bei dem im ersten Teilabschnitt (23) zudem eine erste Leiterschleife oder eine zweite Leiterschleife einer weiteren Differenzsonde und im zweiten Teilabschnitt dem entsprechend eine zweite Leiterschleife oder eine erste Leiterschleife dieser weiteren Differenzsonde ausgebildet werden.

9. Verfahren nach Anspruch 7 oder 8, bei dem die Teilabschnitte (23, 24) mit Referenzbohrungen (25) versehen werden, mittels denen die Teilabschnitte (23, 24) relativ zueinander positionierbar sind.

10. Verfahren nach einem der Ansprüche 7 bis 9, bei dem die Differenzsonde (7, 19) mit mehreren Leiterschleifenpaaren hergestellt wird, wobei alle ersten Leiterschleifen (11, 12, 13) miteinander fluchten und alle zweiten Leiterschleifen (15, 16, 17) miteinander fluchten.

11. Verfahren nach einem der Ansprüche 7 bis 10, bei dem die erste Leiterschleife (11, 12, 13) und die zweite Leiterschleife (15, 16, 17) mit jeweiligen geraden und zur Versetzungsrichtung parallel ausgebildeten Leiterabschnitten hergestellt werden.

12. Verfahren nach einem der Ansprüche 7 bis 11, bei dem die Differenzsonde (7, 19) mit einer von der ersten Leiterschleife (11, 12, 13) umgrenzten ersten Fläche und einer von der zweiten Leiterschleife (15, 16, 17) umgrenzten zweite Fläche hergestellt wird, die sich in Normalenrichtung zur Spiegelebene teilweise überlappen oder disjunkt sind.

## Claims

1. Test apparatus (1) comprising at least one difference probe (7, 19) and at least one passage opening (3) for items under test (6) about which the difference probe (7, 19) can be rotated, wherein
the difference probe (7, 19) has a first half-probe (8, 20) and a second half-probe (9, 21) and
at least one pair of conductor loops comprising a first conductor loop (11, 12, 13) of the first half-probe (8, 20) and a second conductor loop (15, 16, 17) of the second half-probe (9, 21),
**characterized in that**
the first conductor loop (11, 12, 13) and the second conductor loop (15, 16, 17) are formed in a mirror-inverted manner to one another and are arranged offset in relation to one another with respect to a mirror-inverted arrangement of the said conductor loops on respective sides of a mirror plane, in which the first conductor loop (11, 12, 13) and the second conductor loop (15, 16, 17) are oriented parallel to the mirror plane, in an offset direction that is likewise parallel to the mirror plane, wherein
the first conductor loop (11, 12, 13) and the second conductor loop (15, 16, 17) partially overlap in the normal direction to the mirror plane, and wherein
during rotation of the difference probe (7, 19) a centre axis of the passage opening (3) runs substantially parallel to the mirror plane or within the mirror plane.

2. Test apparatus (1) according to Claim 1, in which the difference probe (7, 19) has a plurality of pairs of conductor loops, and in which all of the first conductor loops (11, 12, 13) are in alignment with one another and all of the second conductor loops (15, 16, 17) are in alignment with one another.

3. Test apparatus (1) according to Claim 1 or 2, wherein in the difference probe (7, 19) the first conductor loop (11, 12, 13) and the second conductor loop (15, 16, 17) have respective straight conductor sections that are formed parallel to the offset direction.

4. Test apparatus (1) according to one of the preceding claims, wherein in the difference probe (7, 19) a first area that is bounded by the first conductor loop (11, 12, 13) and a second area that is bounded by the second conductor loop (15, 16, 17) partially overlap or are disjunct in the normal direction to the mirror plane.

5. Test apparatus (1) according to one of the preceding claims, in which two or more difference probes (7, 19) are arranged at substantially identical angular distances around the passage opening (3).

6. Test apparatus (1) according to Claim 5, in which at least two difference probes (7, 19) are arranged next to one another along the offset direction.

7. Method for producing a difference probe (7, 19) which has a first half-probe (8, 20) and a second half-probe (9, 21) and
at least one conductor loop pair comprising a first conductor loop (11, 12, 13) of the first half-probe (8, 20) and a second conductor loop (15, 16, 17) of the second half-probe (9, 21), of which conductor loop pair
the first conductor loop (11, 12, 13) and the second conductor loop (15, 16, 17) are formed in a mirror-inverted manner to one another and are arranged offset in relation to one another with respect to a mirror-inverted arrangement of the said conductor loops on respective sides of a mirror plane, in which the first conductor loop (11, 12, 13) and the second conductor loop (15, 16, 17) are oriented parallel to the mirror plane, in an offset direction that is likewise parallel to the mirror plane, wherein
the first conductor loop (11, 12, 13) and the second conductor loop (15, 16, 17) partially overlap in the normal direction to the mirror plane;
**characterized in that**
the first conductor loop (11, 12, 13) is formed in a first subsection (23) of a planar printed circuit board (22),
the second conductor loop (15, 16, 17) is formed in a second subsection (24) of the printed circuit board (22) in a position that corresponds to the offset of the second conductor loop (15, 16, 17) in relation to the first conductor loop (11, 12, 13) in the finished difference probe (7, 19), wherein the second conductor loop (15, 16, 17) is formed in an orientation that is rotated through 180° about a rotation axis that is parallel to the offset direction in relation to its orientation in the finished second half-probe (9, 21),
the printed circuit board (22) is divided and the first subsection (23) and the second subsection (24) are separated from one another in the process,
the second subsection (24) is arranged next to the first subsection (23), wherein the second conductor loop (15, 16, 17) is moved into its orientation in the finished second half-probe (9, 21), and
the first subsection (23) and the second subsection (24) are connected to one another.

8. Method according to Claim 7, in which a first conductor loop or a second conductor loop of a further difference probe are additionally formed in the first subsection (23) and accordingly a second conductor loop or a first conductor loop of this further difference probe is formed in the second subsection.

9. Method according to Claim 7 or 8, in which the subsections (23, 24) are provided with reference bores (25) by means of which the subsections (23, 24) can be positioned relative to one another.

10. Method according to one of Claims 7 to 9, in which the difference probe (7, 19) is produced with a plurality of conductor loop pairs, wherein all of the first conductor loops (11, 12, 13) are in alignment with one another and all of the second conductor loops (15, 16, 17) are in alignment with one another.

11. Method according to one of Claims 7 to 10, in which the first conductor loop (11, 12, 13) and the second conductor loop (15, 16, 17) are produced with respective straight conductor sections that are formed parallel to the offset direction.

12. Method according to one of Claims 7 to 11, in which the difference probe (7, 19) is produced with a first area that is bounded by the first conductor loop (11, 12, 13) and a second area that is bounded by the second conductor loop (15, 16, 17), the said first area and second area partially overlapping or being disjunct in the normal direction to the mirror plane.

## Revendications

1. Dispositif de contrôle (1) muni d'au moins une sonde de différence (7, 19) et d'au moins une ouverture de passage (3) pour des éléments à contrôler (6), autour de laquelle la sonde de différence (7, 19) peut tourner,
la sonde de différence (7, 19) comprenant une première demi-sonde (8, 20) et une deuxième demi-sonde (9, 21), et
au moins une paire de boucles conductrices munie d'une première boucle conductrice (11, 12, 13) de la première demi-sonde (8, 20) et d'une deuxième boucle conductrice (15, 16, 17) de la deuxième semi-sonde (9, 21),
**caractérisé en ce que**
la première boucle conductrice (11, 12, 13) et la deuxième boucle conductrice (15, 16, 17) sont formées en symétrie de miroir l'une par rapport à l'autre et sont agencées, par rapport à un agencement en symétrie de miroir de ces dernières sur des côtés respectifs d'un plan de miroir dans lequel la première boucle conductrice (11, 12, 13) et la deuxième boucle conductrice (15, 16, 17) sont orientées de manière parallèle par rapport au plan de miroir, de manière décalée l'une par rapport à l'autre dans une direction de décalage également parallèle au plan de miroir,
la première boucle conductrice (11, 12, 13) et la seconde boucle conductrice (15, 16, 17) se chevauchant en partie dans la direction normale par rapport au plan de miroir, et
pendant la rotation de la sonde de différence (7, 19), un axe central de l'ouverture de passage (3) étant essentiellement parallèle au plan de miroir ou à l'intérieur du plan de miroir.

2. Dispositif de contrôle (1) selon la revendication 1, dans lequel la sonde de différence (7, 19) comprend plusieurs paires de boucles conductrices, et dans lequel toutes les premières boucles conductrices (11, 12, 13) sont alignées les unes avec les autres et toutes les deuxièmes boucles conductrices (15, 16, 17) sont alignées les unes avec les autres.

3. Dispositif de contrôle (1) selon la revendication 1 ou 2, dans lequel, dans la sonde de différence (7, 19), la première boucle conductrice (11, 12, 13) et la deuxième boucle conductrice (15, 16, 17) comprennent des sections conductrices respectives droites et configurées de manière parallèle à la direction de décalage.

4. Dispositif de contrôle (1) selon l'une quelconque des revendications précédentes, dans lequel, dans la sonde de différence (7, 19), une première surface délimitée par la première boucle conductrice (11, 12, 13) et une deuxième surface délimitée par la deuxième boucle conductrice (15, 16, 17) se chevauchent en partie dans la direction normale par rapport au plan de miroir ou sont disjointes.

5. Dispositif de contrôle (1) selon l'une quelconque des revendications précédentes, dans lequel deux ou plus de deux sondes de différence (7, 19) sont agencées à des distances angulaires essentiellement identiques autour de l'ouverture de passage (3).

6. Dispositif de contrôle (1) selon la revendication 5, dans lequel au moins deux sondes de différence (7, 19) sont agencées l'une à côté de l'autre le long de la direction de décalage.

7. Procédé de fabrication d'une sonde de différence (7, 19), qui comprend une première demi-sonde (8, 20) et une deuxième demi-sonde (9, 21), et
au moins une paire de boucles conductrices munie d'une première boucle conductrice (11, 12, 13) de la première demi-sonde (8, 20) et d'une deuxième boucle conductrice (15, 16, 17) de la deuxième semi-sonde (9, 21), parmi lesquelles
la première boucle conductrice (11, 12, 13) et la deuxième boucle conductrice (15, 16, 17) sont formées en symétrie de miroir l'une par rapport à l'autre et sont agencées, par rapport à un agencement en symétrie de miroir de ces dernières sur des côtés respectifs d'un plan de miroir dans lequel la première boucle conductrice (11, 12, 13) et la deuxième boucle conductrice (15, 16, 17) sont orientées de manière parallèle par rapport au plan de miroir, de manière décalée l'une par rapport à l'autre dans une direction de décalage également parallèle au plan de miroir,
la première boucle conductrice (11, 12, 13) et la seconde boucle conductrice (15, 16, 17) se chevauchant en partie dans la direction normale par rapport au plan de miroir,
**caractérisé en ce que**
la première boucle conductrice (11, 12, 13) est formée dans une première section partielle (23) d'une platine plate (22),
la deuxième boucle conductrice (15, 16, 17) est formée dans une deuxième section partielle (24) de la platine (22) en une position qui correspond au décalage de la deuxième boucle conductrice (15, 16, 17) par rapport à la première boucle conductrice (11, 12, 13) dans la sonde de différence (7, 19) finie, la deuxième boucle conductrice (15, 16, 17) étant formée dans une orientation tournée de 180° autour d'un axe de rotation parallèle à la direction de décalage par rapport à son orientation dans la deuxième semi-sonde (9, 21) finie,
la platine (22) est divisée, et la première section partielle (23) et la deuxième section partielle (24) sont ainsi séparées l'une de l'autre,
la deuxième section partielle (24) est agencée à côté de la première section partielle (23), la deuxième boucle conductrice (15, 16, 17) étant amenée dans son orientation dans la deuxième demi-sonde (9, 21) finie, et
la première section partielle (23) et la deuxième section partielle (24) sont reliées l'une avec l'autre.

8. Procédé selon la revendication 7, dans lequel, en outre, une première boucle conductrice ou une deuxième boucle conductrice d'une sonde de différence supplémentaire est formée dans la première section partielle (23), et une deuxième boucle conductrice ou une première boucle conductrice de cette sonde de différence supplémentaire est formée en conséquence dans la deuxième section partielle.

9. Procédé selon la revendication 7 ou 8, dans lequel les sections partielles (23, 24) sont munies d'alésages de référence (25), au moyen desquels les sections partielles (23, 24) peuvent être positionnées l'une par rapport à l'autre.

10. Procédé selon l'une quelconque des revendications 7 à 9, dans lequel la sonde de différence (7, 19) est fabriquée avec plusieurs paires de boucles conductrices, toutes les premières boucles conductrices (11, 12, 13) étant alignées les unes avec les autres et toutes les deuxièmes boucles conductrices (15, 16, 17) étant alignées les unes avec les autres.

11. Procédé selon l'une quelconque des revendications 7 à 10, dans lequel la première boucle conductrice (11, 12, 13) et la deuxième boucle conductrice (15, 16, 17) sont fabriquées avec des sections conductrices respectives droites et formées de manière parallèle par rapport à la direction de décalage.

12. Procédé selon l'une quelconque des revendications 7 à 11, dans lequel la sonde de différence (7, 19) est fabriquée avec une première surface délimitée par la première boucle conductrice (11, 12, 13) et une deuxième surface délimitée par la deuxième boucle conductrice (15, 16, 17), qui se chevauchent en partie dans la direction normale par rapport au plan de miroir ou sont disjointes.
